# FASCICULE DE BREVET EUROPEEN

(11) **EP 3 384 601 B1**
(45) Date de publication et mention de la délivrance du brevet: **18.09.2019**
(21) Numéro de dépôt: 16809324.3
(22) Date de dépôt: 02.12.2016
(51) Int. Cl.: H03H 2/00

(54) **FILTRE POUR ONDES RADIOFRÉQUENCE ET DISPOSITIF DE FILTRAGE COMPRENANT UN TEL FILTRE**
HOCHFREQUENZWELLENFILTER UND FILTERVORRICHTUNG MIT SOLCH EINEM FILTER
RADIOFREQUENCY WAVE FILTER AND FILTERING DEVICE INCLUDING SUCH A FILTER

(30) Priorité: 02.12.2015 FR 1502515
(43) Date de publication de la demande: 10.10.2018
(73) Titulaire: Thales, 92400 Courbevoie (FR); Centre National de la Recherche Scientifique, 75016 Paris (FR); Université Paris-Sud, 91405 Orsay (FR)
(72) Inventeur: BORTOLOTTI, Paolo, 91767 Palaiseau (FR); ANANE, Abdelmadjid, 91767 Palaiseau (FR); CROS, Vincent, 91767 Palaiseau (FR); D'ALLIVY KELLY, Olivier, 91767 Palaiseau (FR); MARCILHAC, Bruno, 91767 Palaiseau (FR)
(74) Mandataire: Lavoix
(86) Numéro de dépôt international: PCT/EP2016/079617
(87) Numéro de publication internationale: WO 2017/093498

(56) Documents cités:
- US-A- 4 318 061
- US-A- 4 465 986
- US-A1- 2006 292 704
- US-A1- 2008 231 392
- US-B1- 6 356 165

## Description

La présente invention concerne un filtre pour ondes radiofréquences et un dispositif de filtrage comprenant une pluralité de tels filtres.

Les ondes électromagnétiques radiofréquences, également dénommées ondes radioélectriques, sont les ondes électromagnétiques dont la fréquence est prise entre 3 KiloHertz (kHz) et 100 GigaHertz (GHz). Les ondes radioélectriques sont utilisées dans de nombreuses applications. En particulier, certaines fréquences d'ondes radioélectriques sont très peu atténuées par l'atmosphère terrestre. Les ondes radioélectriques, et en particulier les ondes radioélectriques dont la fréquence est supérieure ou égale à 3 MégaHertz, sont donc fréquemment utilisées pour les applications de type télécommunication et/ou radar.

Il est donc important pour un dispositif récepteur d'ondes radioélectriques, de filtrer le signal reçu, c'est-à-dire de supprimer les composantes radiofréquences inutiles, et de ne conserver que la composante radiofréquence porteuse d'informations. Or, de nombreux dispositifs à ondes électromagnétiques radiofréquences sont configurés pour fonctionner à une fréquence variable. Il est donc fréquent pour ce type d'application d'utiliser un dispositif de filtrage accordable, c'est-à-dire dont la fréquence peut être modifiée.

A l'heure actuelle, un grand nombre de filtres accordables utilise la résonance de cristaux de YIG (grenat d'yttrium et de fer, en Anglais « Yttrium-lron Garnet ») couplant deux conducteurs électriques. Cette structure forme un filtre passe-bande centré autour de la fréquence de résonance du cristal. La fréquence de résonance du cristal dépend de la valeur d'un champ magnétique extérieur fréquemment généré par un électro-aimant. Un tel filtre permet ainsi d'accorder la fréquence en faisant varier l'intensité du courant traversant l'électro-aimant.

Cependant, de tels filtres comprenant un électro-aimant présentent des dimensions assez importantes, de l'ordre du centimètre, et consomment un courant de l'ordre de plusieurs dizaines voire centaines de milliampères. De plus, le temps de réponse, c'est-à-dire le temps nécessaire pour modifier la fréquence du filtre, est de l'ordre de quelques millisecondes.

Il a été proposé, par exemple, dans le brevet français FR 2 546 672 B1, d'utiliser un dispositif de filtrage d'ondes radiofréquences basé sur la propagation d'ondes de spin dans des films minces ferromagnétiques. En effet, les ondes de spin (également dénommées ondes magnétostatiques) ont, à fréquence égale, des longueurs d'ondes très inférieures à la longueur d'ondes des ondes radiofréquences dans l'atmosphère.

Le document US 2011/0102106 A1 décrit un dispositif à ondes magnétostatiques réalisant un filtrage passe-bande d'une onde magnétostatique radiofréquence. Ce dispositif utilise un film mince de matériaux ferromagnétiques structuré périodiquement, dans lequel seules certaines gammes de fréquence peuvent se propager. Le contrôle, par une structuration du matériau, du spectre de fréquences se propageant dans une couche mince est également connu dans d'autres domaines, tels que, par exemple, les cristaux photoniques. Un tel filtre présente l'avantage d'être robuste, et de petites dimensions (quelques dizaines de microns).

Cependant, un tel dispositif n'est pas commutable. En effet, les propriétés du filtrage de ces dispositifs, telles que la fonction de transfert, ou le type de filtrage (passe-bande, coupe-bande ou passe-bas), sont fixées définitivement par la structuration du matériau. Afin d'obtenir une fonction de commutation, des commutateurs radiofréquence extérieurs sont fréquemment utilisés. Cependant, l'ajout de tels commutateurs extérieurs augmente à la fois la complexité et les dimensions de ces filtres.

Le document US4465986 A décrit un dispositif à ondes magnétostatiques commutable comprenant un organe de contrôle agencé pour modifier la vitesse de propagation des ondes magnétostatiques.

Il existe donc un besoin pour un filtre fonctionnant dans la gamme radiofréquence, qui soit à la fois commutable de petites dimensions, et peu consommateur d'énergie.

A cet effet, l'invention propose un filtre pour ondes radiofréquences comprenant :
- une unité de guidage d'ondes de spin comprenant un matériau magnétique, l'unité de guidage étant agencée spatialement pour générer un potentiel magnétostatique modulé spatialement, le potentiel magnétostatique permettant la propagation d'ondes de spin présentant une fréquence appartenant à un premier ensemble de fréquences et empêchant la propagation d'ondes de spin présentant une fréquence appartenant à un deuxième ensemble de fréquences, le deuxième ensemble de fréquences étant distinct du premier ensemble de fréquences, un taux de transmission étant défini pour l'unité de guidage, le taux de transmission étant égal au rapport de la deuxième amplitude de l'onde en sortie de l'unité de guidage et de la première amplitude de l'onde en entrée de l'unité de guidage,
- un élément d'entrée de l'unité de guidage, l'élément d'entrée étant apte à convertir avec un premier rendement, une onde électromagnétique radiofréquence en une onde de spin,
- un élément de sortie de l'unité de guidage, l'élément de sortie étant apte à convertir avec un deuxième rendement, une onde de spin en un signal de sortie radiofréquence,
- une unité de génération d'au moins un signal électrique de commande, et
- un organe de contrôle propre à modifier l'un au moins parmi le premier rendement, le deuxième rendement et le taux de transmission en réponse au signal de commande que l'unité de génération est propre à générer, l'organe de contrôle comportant une couche en contact avec l'unité de guidage et deux électrodes configurées pour permettre la transmission du signal électrique de commande à travers ladite couche en contact avec l'unité de guidage.

Suivant des modes de réalisation particuliers, le filtre pour ondes radiofréquences comprend une ou plusieurs des caractéristiques suivantes, prises isolément ou suivant toutes les combinaisons techniquement possibles :
- l'élément d'entrée comprend une portion active, la portion active étant réalisée en un matériau magnétique, l'organe de contrôle comportant un premier empilement d'au moins une première couche magnétique, et d'une couche non magnétique, la direction d'aimantation de la première couche magnétique étant fixe, et l'organe de contrôle étant propre à modifier la direction de l'aimantation de la portion active ;
- l'organe de contrôle comprend une couche de modulation ayant une première face en contact avec l'unité de guidage, l'organe de contrôle étant apte à provoquer l'accumulation à la première face d'électrons présentant une même valeur de spin ;
- l'organe de contrôle est propre à modifier la deuxième amplitude entre une première valeur et une deuxième valeur, la deuxième valeur étant supérieure à la première amplitude ;
- l'élément de sortie comporte un deuxième empilement de couches magnétiques et non magnétiques comprenant au moins une couche réalisée en un matériau magnétique, dite couche de référence, dont la direction de l'aimantation est fixée, et au moins une couche réalisée en un matériau non magnétique, dite couche barrière, l'élément de sortie étant propre à générer un courant électrique traversant successivement au moins la couche de référence et la couche barrière ;
- l'unité de guidage est propre à permettre la propagation d'une onde de spin dans une direction de propagation, l'unité de guidage comportant des premières portions réalisées en matériau dopé et des deuxièmes portions réalisées en matériau non dopé, les premières portions étant arrangées sous forme d'un motif répété périodiquement dans la direction de propagation de l'onde de spin ;
- l'unité de guidage est propre à permettre la propagation d'une onde de spin dans une direction de propagation, l'unité de guidage comportant une couche de propagation réalisée en un matériau magnétique, la couche de propagation présentant une pluralité de trous borgnes, les trous étant arrangés sous forme d'un motif répété périodiquement dans la direction de propagation de l'onde de spin.

En outre, l'invention se rapporte également à un dispositif de filtrage comprenant une pluralité de filtres tels que décrit précédemment générant une pluralité de signaux de sortie, la pluralité de filtres comprenant un premier filtre comportant une première unité de génération de signal de commande et au moins un deuxième filtre comportant une deuxième unité de génération de signal de commande, le deuxième filtre étant différent du premier filtre, dans lequel la première unité de génération de signal de commande est indépendante de la deuxième unité de génération de signal de commande.

De plus, l'invention se rapporte également à un dispositif de filtrage comprenant une pluralité de filtres tels que décrit précédemment générant une pluralité de signaux de sortie, la pluralité de filtres comprenant un premier filtre et au moins un deuxième filtre différent du premier filtre, le premier filtre comprenant un premier organe de contrôle commandé par un signal de commande et le deuxième filtre comprenant un deuxième organe de contrôle commandé par le même signal de commande.

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un filtre pour ondes radiofréquences.
- les figures 2 à 6 sont des vues en coupe partielles de filtres selon la figure 1 ;
- les figures 7 et 8 sont des vues schématiques de dessus partielles de filtres de la figure 1 ; et
- les figures 9 à 11 sont des diagrammes de dispositifs de filtrage comprenant une pluralité de filtres.

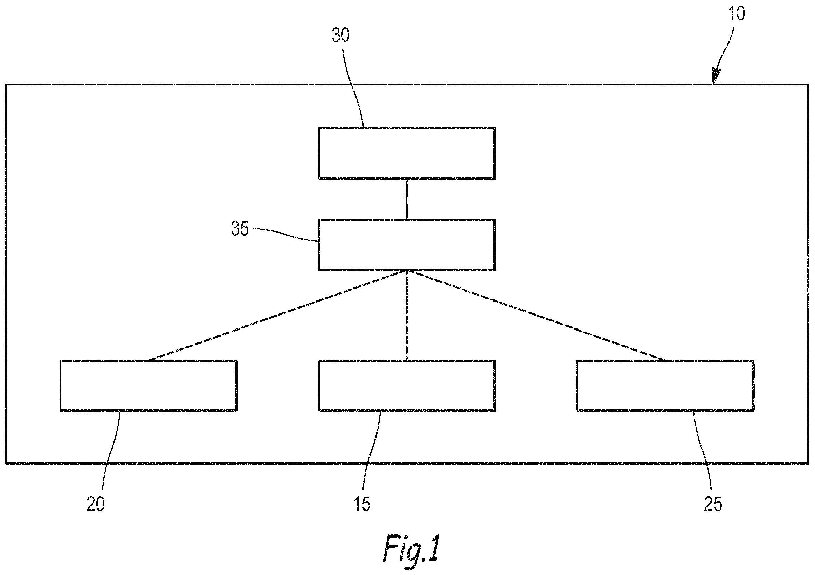

Un filtre 10 pour ondes radiofréquences est représenté schématiquement sur la figure 1.

Le filtre 10 est apte à recevoir en entrée un signal d'entrée OE radiofréquence comprenant au moins une composante d'entrée radiofréquence, et pour générer, à partir du signal d'entrée OE, un signal de sortie OS.

Le signal d'entrée OE est, par exemple, un signal électrique.

De préférence, le signal d'entrée OE est une onde électromagnétique d'entrée OE.

Il est entendu, pour une onde, par le terme « présentant une composante radiofréquence », qu'il existe au moins une décomposition de l'onde dans laquelle l'onde est la somme de plusieurs ondes dont au moins une présente une fréquence comprise entre 3 kHz et 3 GHz.

Il est, en outre, entendu, pour un signal électrique, par le terme « présentant une composante radiofréquence » qu'il existe au moins une décomposition du signal dans laquelle le signal est la somme de plusieurs signaux dont au moins un présente une fréquence comprise entre 3 kHz et 3 GHz.

L'onde électromagnétique d'entrée OE présente une amplitude d'entrée AE. L'amplitude d'entrée AE est définie comme étant la norme euclidienne du champ électrique de l'onde électromagnétique d'entrée OE.

Le signal de sortie OS est, par exemple, un courant électrique variable. Le signal de sortie OS présente une amplitude de sortie AS. Par définition, l'amplitude de sortie est la différence entre la valeur maximale et la valeur minimale du signal de sortie OS, en valeur absolue.

Le signal de sortie OS est, de préférence, un signal de sortie radiofréquence. Par exemple, le signal de sortie OS est un courant électrique variable présentant au moins une fréquence de sortie comprise strictement entre 3 kHz et 3 GHz. Le signal de sortie OS présente, de préférence, une pluralité de composantes radiofréquences de sortie.

Le filtre 10 présente une fonction de transfert F, définie comme étant le rapport de l'amplitude de sortie AS et de l'amplitude d'entrée AE. La fonction de transfert F dépend de la fréquence f de l'onde électromagnétique d'entrée.

Le filtre 10 présente un premier ensemble de fréquences E1 pour lesquelles la fonction de transfert F est non nulle. Le filtre 10 présente, en outre, un deuxième ensemble de fréquences E2 pour lesquelles la fonction de transfert F est inférieure ou égale à 10⁻⁵.

Le premier ensemble de fréquences E1 et le deuxième ensemble de fréquences E2 comportent chacun au moins une fréquence comprise entre 3 kHz et 3 GHz. Le premier ensemble de fréquences E1 et le deuxième ensemble de fréquences E2 sont distincts. Cela signifie qu'il existe au moins une fréquence particulière Fₚₐᵣ qui n'appartient pas à la fois au premier ensemble de fréquence E1 et au deuxième ensemble E2.

De préférence, le premier ensemble de fréquences E1 et le deuxième ensemble de fréquences E2 sont disjoints. Cela signifie qu'il n'existe pas de fréquence commune F_{com} qui appartienne à la fois au premier ensemble de fréquences E1 et au deuxième ensemble de fréquences E2.

Le premier ensemble de fréquences E1 est, par exemple, continu. Cela signifie que le filtre 10 présente une première fréquence de coupure F_{c1} et une deuxième fréquence de coupure F_{c2}, et toutes les fréquences f comprises strictement entre la première fréquence de coupure F_{c1} et la deuxième fréquence de coupure F_{c2} sont comprises dans le premier ensemble de fréquences E1. Par exemple, le filtre 10 est de type passe-bande.

En variante, le deuxième ensemble de fréquence est continu. Cela signifie que le filtre 10 présente une troisième fréquence de coupure F_{c3} et une quatrième fréquence de coupure F_{c4}, et toutes les fréquences f comprises strictement entre la troisième fréquence de coupure F_{c3} et la quatrième fréquence de coupure F_{c4} sont comprises dans le deuxième ensemble de fréquences E2. Par exemple, le filtre 10 est de type coupe-bande.

Le filtre 10 comprend une unité de guidage 15, un élément d'entrée 20, un élément de sortie 25, une unité de génération 30 et un organe de contrôle 35.

Dans la suite de cette description, il est entendu par le terme « matériau magnétique », un matériau présentant une aimantation orientée selon une direction d'aimantation spécifique. Cela signifie que le matériau comprend une pluralité de moments magnétiques, et la résultante des moments magnétiques est un vecteur non nul. La direction d'aimantation est définie comme étant la direction de la résultante des moments magnétiques. Les moments magnétiques sont, par exemple, portés par des électrons présents dans le matériau.

En particulier, le terme « matériau magnétique » sera utilisé pour un matériau ferromagnétique ou un matériau ferrimagnétique.

Dans un matériau ferromagnétique, les moments magnétiques sont orientés parallèlement les uns aux autres. Lorsqu'un matériau ferromagnétique est soumis à un champ magnétique extérieur, les moments magnétiques du matériau s'orientent, en restant parallèles les uns aux autres, dans la direction du champ magnétique extérieur.

Dans un matériau ferrimagnétique, les moments magnétiques sont orientés antiparallèlement les uns aux autres, sans pour autant se compenser parfaitement.

La résultante des moments dans un matériau ferrimagnétique est strictement inférieure à la résultante des moments dans ce même matériau, s'il était ferromagnétique. Lorsqu'un matériau ferrimagnétique est soumis à un champ magnétique extérieur, les moments magnétiques du matériau s'orientent, tout en restant antiparallèles les uns aux autres, de telle sorte que la résultante soit orientée dans la direction du champ magnétique extérieur.

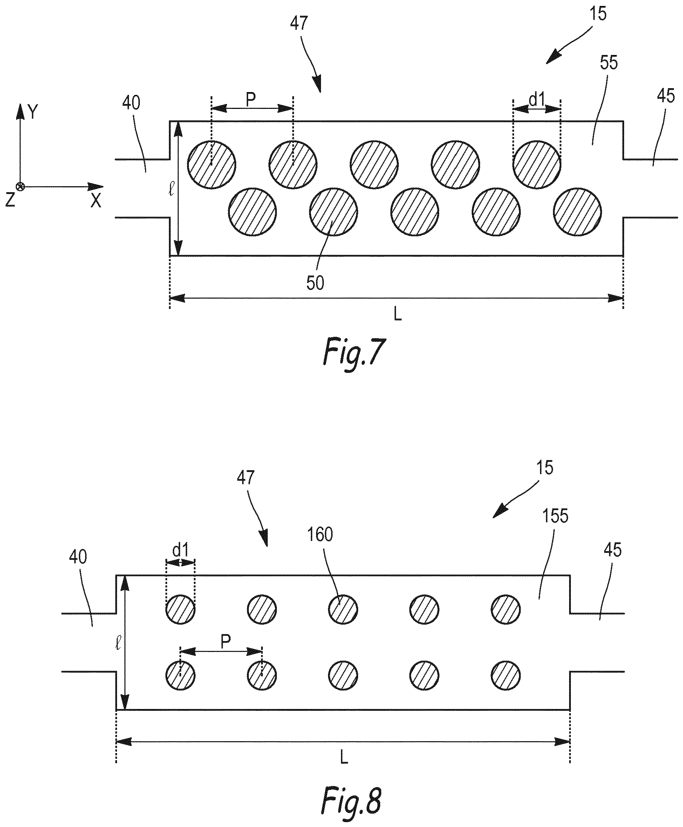

L'unité de guidage 15 comprend une portion d'entrée 40, une portion de sortie 45 et une portion structurée 47. Cela est notamment visible sur les figures 7 et 8.

L'unité de guidage 15 est propre à permettre la propagation d'au moins une onde de spin SW entre la portion d'entrée 40 et la portion de sortie 45.

L'unité de guidage 15 comprend un premier matériau magnétique M1 présentant une première direction d'aimantation D1.

Le premier matériau magnétique M1 est, par exemple, un matériau ferrimagnétique.

Le premier matériau magnétique M1 est, par exemple, un grenat de fer et d'yttrium (YIG).

Le premier matériau ferrimagnétique M1 est, par exemple, soumis à un premier champ magnétique externe B1 orienté dans la première direction d'aimantation D1.

En variante, le premier matériau magnétique M1 est un matériau ferromagnétique.

Lorsque le premier matériau magnétique M1 est soumis à un deuxième champ magnétique externe B2 non parallèle au premier champ magnétique B1, les moments magnétiques présents dans le premier matériau magnétique M1 subissent une force magnétique F_{M}. Les moments magnétiques sont alors déviés par rapport à la première direction d'aimantation D1.

Si le deuxième champ magnétique externe B2 est variable, les moments magnétiques suivent un mouvement de précession autour de la première direction d'aimantation D1. Ce mouvement de précession se propage de proche en proche dans le premier matériau magnétique M1, et se traduit par une variation locale de la direction de l'aimantation du premier matériau magnétique M1. Cette déviation locale de l'aimantation se propageant dans le premier matériau magnétique M1 est appelée « onde de spin ».

La portion d'entrée 40 est propre à recevoir de l'élément d'entrée 20 une onde de spin SW et à délivrer l'onde de spin SW à la portion structurée 47.

La portion de sortie 45 est propre à recevoir de la portion structurée 47 une onde de spin SW et à délivrer l'onde de spin SW à l'élément de sortie 25.

Dans la portion d'entrée 40, l'onde de spin SW présente une première amplitude A1.

Dans la portion de sortie 45, l'onde de spin SW présente une deuxième amplitude A2. Il est défini, pour l'unité de guidage 15, un taux de transmission T de l'onde de spin SW égal au rapport entre la deuxième amplitude A2 et la première amplitude A1. Cela s'écrit mathématiquement T = A2/A1.

L'amplitude d'une onde de spin SW est définie comme étant l'angle maximum entre le moment magnétique et la première direction d'aimantation. L'amplitude de l'onde de spin SW est, par exemple, mesurée par des méthodes inductives ou par des techniques de microscopies telles que la diffraction Brillouin ou la microscopie Kerr.

La portion structurée 47 de l'unité de guidage 15 est agencée spatialement pour générer un potentiel magnétostatique modulé spatialement.

Cela signifie que la portion structurée 47 présente au moins une première portion 50 dans laquelle le champ magnétique présente une première valeur B et au moins une deuxième portion 55 dans laquelle le champ magnétique présente une deuxième valeur B' différente de la première valeur B. La première portion 50 est séparée spatialement de la deuxième portion 55.
En conséquence, les moments magnétiques présents dans la première portion 50 et la deuxième portion 55 subissent des forces magnétiques différentes. Il en résulte qu'une onde de spin O se propageant dans la deuxième portion 55 en présence du potentiel induit par la première portion 50 et présentant une amplitude initiale Ai dans la portion d'entrée 40 présente une amplitude finale Af différente de l'amplitude initiale Ai dans la portion de sortie 45.

Le potentiel magnétostatique est propre à permettre la propagation d'ondes de spin SW présentant une fréquence comprise dans le premier ensemble de fréquences E1 entre la portion d'entrée 40 et la portion de sortie 45. Le potentiel magnétique est, en outre, propre à empêcher la propagation entre la portion d'entrée 40 et la portion de sortie 45 d'ondes de spin SW présentant une fréquence comprise dans le deuxième ensemble de fréquences E2.

Dans la portion structurée 47, l'onde de spin SW présente une amplitude variable A. L'amplitude variable A varie avec la position dans la portion structurée 47.

L'amplitude variable A varie exponentiellement en fonction de la distance d entre la position dans la portion structurée 47 et la portion d'entrée 40.

Il est défini un coefficient d'atténuation α tel que l'amplitude variable A varie exponentiellement en fonction du produit du coefficient d'atténuation α par la distance d. Cela s'écrit mathématiquement : A = A1e^{-αd}.

Si la portion structurée 47 présente une longueur L, la deuxième amplitude A2 peut donc s'écrire mathématiquement A2 = A1e^{-αL}.

Selon un exemple de réalisation particulier, les premières portions 50 et les deuxièmes portions 55 sont alternées suivant une direction de propagation de l'onde de spin. La direction de propagation sera notée X par la suite.

De préférence, l'alternance des premières portions 50 et des deuxièmes portions 55 forme un motif périodique suivant la direction de propagation X. Par exemple, le motif est répété avec une période P comprise entre 2 nanomètres (nm) et 10 micromètres (µm).

L'élément d'entrée 20 est apte à recevoir l'onde électromagnétique d'entrée OE et à générer, à partir de l'onde électromagnétique d'entrée OE, une onde de spin SW présentant une première amplitude A1 dans la portion d'entrée 40 de l'unité de guidage 15.

L'élément d'entrée 20 présente un premier rendement R1 égal au rapport de la première amplitude et de l'amplitude d'entrée. Cela s'écrit mathématiquement R1 = A1/AE.

L'élément de sortie 25 est apte à recevoir de l'unité de guidage 15 une onde de spin SW et à générer à partir de l'onde de spin SW reçue le signal de sortie radiofréquence.

L'élément de sortie 25 présente un deuxième rendement R2 égal au rapport de l'amplitude de sortie AS et de la deuxième amplitude A2. Cela s'écrit donc mathématiquement R2 = AS/A2.

L'unité de génération 30 est apte à générer au moins un signal de commande et à communiquer le signal de commande à l'organe de contrôle 35.

Le signal de commande est un courant électrique variable. Par exemple, le signal de commande est une impulsion électrique.

En variante, le signal de commande est un courant électrique continu.

L'unité de génération 30 comporte, par exemple, une alimentation électrique de commande (non représentée).

Lorsque le filtre 10 est dans un premier état, dit «état passif », l'unité de génération 30 est inactive. Cela signifie que l'unité de génération 30 ne génère pas de signal de commande.

Lorsque le filtre 10 est dans un deuxième état, dit «état actif», l'unité de génération 30 est active. Cela signifie que l'unité de génération 30 génère un signal de commande.

L'organe de contrôle 35 est propre à modifier l'un au moins parmi le premier rendement R1, le deuxième rendement R2 et le taux de transmission T en réponse au signal de commande.

De préférence, l'organe de contrôle 35 est apte à rendre l'un au moins parmi le premier rendement, le deuxième rendement et le taux de transmission inférieur ou égal à 10⁻⁵.

Le fonctionnement du filtre 10 va maintenant être décrit.

Le filtre 10 est dans l'état « passif ».

Une onde électromagnétique d'entrée OE radiofréquence est captée par l'élément d'entrée 20. L'onde électromagnétique d'entrée OE présente une pluralité de composantes radiofréquences d'entrée. Les composantes radiofréquences d'entrée présentent un troisième ensemble de fréquences E3.

L'élément d'entrée 20 génère, à partir de l'onde électromagnétique d'entrée OE, une onde de spin SW présentant une pluralité de premières composantes radiofréquences dans la portion d'entrée 40. Les premières composantes radiofréquences présentent un quatrième ensemble de fréquences E4.

De préférence, au moins une des premières composantes radiofréquences et au moins une des composantes radiofréquences d'entrée présentent la même fréquence.

L'onde de spin SW se propage ensuite dans la portion d'entrée 40 et atteint la portion structurée 47.

Les premières composantes radiofréquences qui présentent une fréquence comprise dans le premier ensemble de fréquences E1 se propagent à travers la portion structurée 47 jusqu'à la portion de sortie 45.

Les premières composantes radiofréquences qui présentent une fréquence comprise dans le deuxième ensemble de fréquences E2 ne se propagent pas à travers la portion structurée 47.

L'élément de sortie 25 génère le signal de sortie à partir de l'onde de spin SW. Le signal de sortie OS présente des composantes radiofréquences de sortie. Les composantes radiofréquences de sortie présentent un cinquième ensemble de fréquences E5.

Par exemple, le cinquième ensemble de fréquences E5 est identique au premier ensemble de fréquences E1.

Ensuite, l'unité de génération 30 est activée. Le filtre 10 passe alors dans l'état « actif ».

Dans le cas où l'organe de contrôle 35 est propre à rendre le premier rendement R1 inférieur ou égal à 10⁻⁵, la première amplitude A1 de chacune des premières composantes radiofréquences est inférieure ou égale à 10⁻⁵. Cela signifie que l'élément d'entrée 20 ne génère pas d'onde de spin SW.

L'amplitude de sortie AS de chacune des composantes radiofréquences de sortie est alors inférieure ou égale à 10⁻⁵.

Dans le cas où l'organe de contrôle 35 est propre à modifier le taux de transmission, l'élément d'entrée 20 génère, à partir de l'onde électromagnétique radiofréquence, une onde de spin présentant une pluralité de premières composantes radiofréquences dans la portion d'entrée 40.

De préférence, au moins une des premières composantes radiofréquences et au moins une des composantes radiofréquences d'entrée présentent la même fréquence.

L'onde de spin se propage dans la portion d'entrée 40 et atteint la portion structurée 47. En sortie de l'unité de guidage 15, la deuxième amplitude A2 de chacune des premières composantes radiofréquences est alors inférieure ou égale à 10⁻⁵. Le signal de sortie OS présente alors une amplitude de sortie AS inférieure ou égale à 10⁻⁵.

Dans le cas où l'organe de contrôle 35 est propre à modifier le deuxième rendement, l'élément d'entrée 20 génère, à partir de l'onde électromagnétique radiofréquence, une onde de spin présentant une pluralité de premières composantes radiofréquences dans la portion d'entrée 40.

De préférence, au moins une des premières composantes radiofréquences et au moins une des composantes radiofréquences d'entrée présentent la même fréquence. L'onde de spin se propage à travers la portion d'entrée 40 et la portion structurée 47, jusqu'à atteindre l'élément de sortie 25. L'amplitude de sortie AS de chacune des composantes radiofréquences de sortie est inférieure ou égale à 10⁻⁵.

Le filtre 10 est commutable, par commande de l'unité de génération 30.

De plus, les courants électriques mis en oeuvre sont de l'ordre de quelques milliampères. Le filtre 10 est donc également économe en énergie par rapport à un filtre commutable utilisant un cristal de YIG.

Selon un premier exemple de réalisation, l'unité de guidage 15 est réalisée sous la forme d'une couche du premier matériau magnétique M1. L'unité de guidage 15 est sensiblement planaire. L'unité de guidage 15 est perpendiculaire à une direction d'empilement Z.

L'unité de guidage 15 est portée par un substrat (non représenté). Par exemple, la direction d'empilement Z est perpendiculaire à la surface du substrat.

L'unité de guidage 15 présente une première épaisseur e1 inférieure ou égale à 100 nanomètres (nm). De préférence, la première épaisseur e1 est comprise entre 5 et 20 nanomètres.

Toutes les épaisseurs sont mesurées selon la direction d'empilement Z.

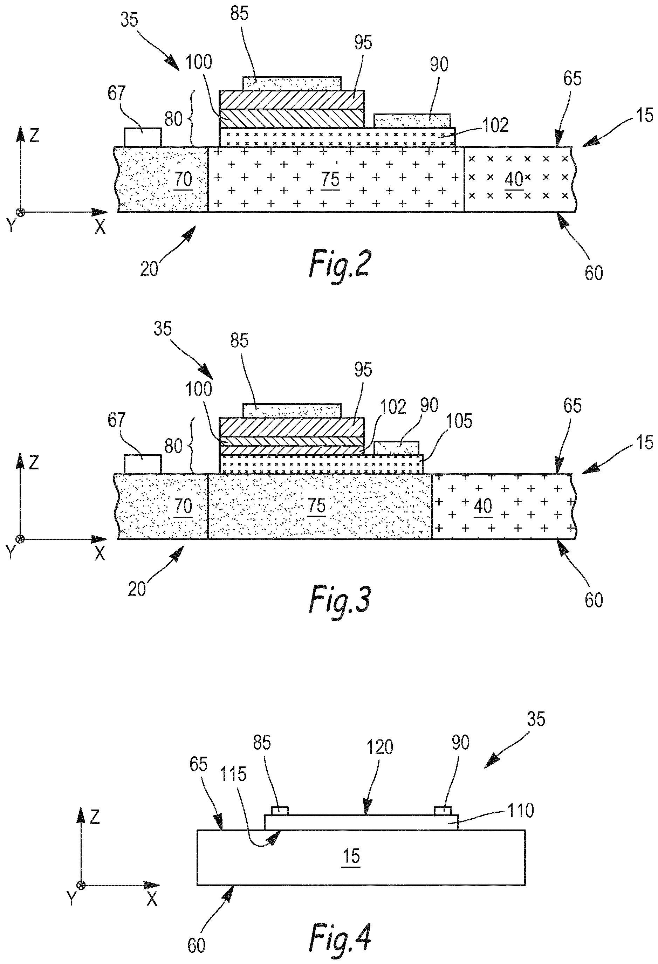

Sur la figure 2, l'unité de guidage 15 présente une première face 60 en contact avec le substrat et une deuxième face 65 en regard de la première face 60. La première face 60 et la deuxième face 65 sont, par exemple, planes. La première face 60 et la deuxième face 65 sont, de préférence, parallèles entre elles.

L'élément d'entrée 20 comporte une antenne 67, une portion de génération 70 et une portion active 75. Selon la direction de propagation X, la portion active 75 est, de préférence, délimitée par la portion de génération 70 et la portion d'entrée 40.

L'antenne 67 est en contact avec la portion de génération 70. L'antenne 67 est apte à recevoir une onde électromagnétique d'entrée OE radiofréquence et à générer, à partir de l'onde électromagnétique d'entrée OE, une onde de spin SW dans la portion de génération 70.

L'antenne 67 est, par exemple, réalisée sous la forme d'une couche de métal. L'antenne 67 est, par exemple, réalisée en or.

L'antenne 67 présente, par exemple, une deuxième épaisseur e2 comprise entre 50 nm et 1 µm, par exemple égale à 250 nm.

L'antenne 67 est, par exemple, une antenne ruban alimentée par un guide d'onde coplanaire.

La portion de génération 70 est apte à délivrer l'onde de spin SW à la portion active 75.

La portion de génération 70 est réalisée sous la forme d'une couche du premier matériau magnétique M1. Par exemple, la portion de génération 70 est réalisée en YIG.

De préférence, la portion de génération 70 est venue de matière avec l'unité de guidage 15. La portion de génération 70 est sensiblement planaire. La portion de génération 70 est, de préférence, perpendiculaire à la direction d'empilement Z.

La portion de génération 70 présente une troisième épaisseur e3. De préférence, la troisième épaisseur e3 est égale à la première épaisseur e1.

La portion de génération 70 présente une aimantation dans la première direction d'aimantation D1. Par exemple, la portion de génération 70 est soumise au premier champ magnétique B1.

La portion active 75 présente une première direction variable d'aimantation V1. Par exemple, la première direction variable d'aimantation V1 est parallèle à la première direction d'aimantation D1. Par exemple, la portion active 75 est soumise au premier champ magnétique B1.

La portion active 75 est apte à permettre la propagation d'une onde de spin entre la portion de génération 70 et la portion d'entrée 40 lorsque la première direction variable d'aimantation V1 est parallèle à la première direction d'aimantation D1.

La portion active 75 est réalisée sous la forme d'une couche du premier matériau magnétique M1. De préférence, la portion active 75 est venue de matière avec l'unité de guidage 15. La portion active 75 est sensiblement planaire. La portion active 75 est, de préférence, perpendiculaire à la direction d'empilement Z.

La portion active 75 présente la troisième épaisseur e3.

La portion active 75 est apte à empêcher la propagation d'une onde de spin entre la portion de génération 70 et la portion d'entrée 40 lorsque la première direction variable d'aimantation V1 est perpendiculaire à la première direction d'aimantation D1.

L'organe de contrôle 35 est apte à faire varier la première direction variable d'aimantation V1 entre la première direction d'aimantation D1 et une deuxième direction d'aimantation D2. La deuxième direction d'aimantation D2 est, de préférence, perpendiculaire à la première direction d'aimantation D1, par exemple parallèle à la direction Y représentée sur la figure 2.

Sur la figure 2, l'organe de contrôle 35 comporte un premier empilement 80 de couches magnétiques et non magnétiques, une première électrode d'entrée 85 et une première électrode de sortie 90.

De préférence, l'organe de contrôle 35 est configuré pour recevoir le signal de commande sur la première électrode d'entrée 85 et pour transmettre le signal de commande, à travers le premier empilement 80, à la première électrode de sortie 90.

De préférence, l'organe de contrôle 35 est configuré pour que le signal de commande traverse successivement la première électrode d'entrée 85, chacune des couches de deuxième empilement 80, puis la première électrode de sortie 90.

Le premier empilement 80 comprend une première couche magnétique 95, une première couche non magnétique 100 et une deuxième couche magnétique 102. De préférence, la première couche magnétique 95, la première couche non magnétique 100 et la deuxième couche magnétique 102 sont superposées.

Le premier empilement 80 est délimité, selon la direction d'empilement Z, par la première électrode d'entrée 85 et la portion active 75.

Sur la figure 2, la première électrode d'entrée 85 est réalisée sous la forme d'une couche de métal. La première électrode d'entrée 85 est, par exemple, réalisée par dépôt d'une couche de métal sur la première couche magnétique 95.

La première électrode d'entrée 85 est, par exemple, réalisée en or.

Sur la figure 2, la première électrode de sortie 90 est réalisée sous la forme d'une couche de métal. La première électrode de sortie 90 est par exemple, réalisée par dépôt d'une couche de métal sur la deuxième couche magnétique 102.

La première électrode de sortie 90 est, par exemple, réalisée en or.

La première électrode de sortie 90 est délimitée, selon la direction d'empilement Z, par la deuxième couche magnétique 102. La première couche magnétique 95 est réalisée en un deuxième matériau magnétique M2. La première couche magnétique 95 est, par exemple, réalisée en un matériau ferromagnétique. La première couche magnétique 95 est, par exemple, réalisée en un alliage de cobalt, de fer et de bore.

La première couche magnétique 95 est sensiblement planaire. La première couche magnétique 95 est, de préférence, perpendiculaire à la direction d'empilement Z.

La première couche magnétique 95 présente une quatrième épaisseur e4. La quatrième épaisseur e4 est, par exemple, comprise entre 1 nanomètre et 30 nanomètres.

La première couche magnétique 95 présente une troisième direction d'aimantation D3. La troisième direction d'aimantation D3 est fixe.

La troisième direction d'aimantation D3 est différente de la première direction d'aimantation D1. Par exemple, la troisième direction d'aimantation D3 est perpendiculaire à la première direction d'aimantation D1. De préférence, la troisième direction d'aimantation D3 est parallèle à la deuxième direction d'aimantation D2.

La première couche non magnétique 100 est sensiblement planaire. La couche non magnétique 100 est, de préférence, perpendiculaire à la direction d'empilement Z.

Selon la direction d'empilement Z, la couche non magnétique 100 est délimitée par la première couche magnétique 95 et la deuxième couche magnétique 102.

La première couche non magnétique 100 présente une cinquième épaisseur e5. La cinquième épaisseur e5 est comprise, par exemple, entre 1 nanomètre et 5 nanomètres.

La première couche non magnétique 100 est réalisée en un matériau non magnétique. La première couche non magnétique 100 est, par exemple, réalisée en oxyde de magnésium.

La deuxième couche magnétique 102 est réalisée en un troisième matériau magnétique M3. La deuxième couche magnétique 102 est, par exemple, réalisée en un matériau ferromagnétique. La deuxième couche magnétique 102 est, par exemple, réalisée en un alliage de nickel et de fer.

La deuxième couche magnétique 102 est sensiblement planaire. La deuxième couche magnétique 102 est, de préférence, perpendiculaire à la direction d'empilement Z.

La deuxième couche magnétique 102 présente une sixième épaisseur e6. La sixième épaisseur e6 est, par exemple, comprise entre 1 nanomètre et 30 nanomètres.

La deuxième couche magnétique 102 présente une deuxième direction variable d'aimantation V2. La deuxième direction variable d'aimantation V2 est variable entre la première direction d'aimantation D1 et la troisième direction d'aimantation D3.

Le fonctionnement du premier exemple de réalisation va maintenant être décrit.

Par effet de « couplage direct », la première direction variable d'aimantation V1 et la deuxième direction variable d'aimantation V2 sont parallèles.

Il est entendu par « couplage direct » que les moments magnétiques présents dans la portion active 75 s'orientent parallèlement aux moments magnétiques présents dans la deuxième couche magnétique 102 avec lesquels ils sont en contact.

Initialement, l'unité de génération 30 est inactive.

La deuxième direction variable d'aimantation V2 est parallèle à la première direction d'aimantation D1. La première direction variable d'aimantation V1 est donc parallèle à la première direction d'aimantation D1.

Le filtre 10 est dans l'état passif.

L'onde électromagnétique d'entrée OE génère dans l'antenne 67 un courant électrique d'entrée IE.

Le courant électrique d'entrée IE présente une pluralité de deuxièmes composantes radiofréquences. De préférence, au moins une des deuxièmes composantes radiofréquences et au moins une des composantes radiofréquences d'entrée présentent la même fréquence.

Le courant électrique d'entrée IE génère un champ magnétique d'entrée BE dans la portion de génération 70.

Le champ magnétique d'entrée BE impose un premier couple magnétique F1 aux moments magnétiques présents dans la portion de génération 70. En particulier, le champ magnétique d'entrée BE impose aux moments magnétiques un mouvement de précession autour de la direction d'aimantation D1.

Le champ magnétique d'entrée BE génère donc une onde de spin SW dans la portion de génération 70.

L'onde de spin se propage dans la portion de génération 70 jusqu'à atteindre la portion active 75. Comme la première direction variable d'aimantation V1 est parallèle à la première direction d'aimantation D1, l'onde de spin se propage à travers la portion active 75 dans la direction de propagation X.

En sortie de la portion active 75, l'onde de spin à une deuxième amplitude A2.

L'unité de génération 30 est ensuite activée. L'unité de génération 30 délivre un signal de commande à l'organe de contrôle 35.

Le signal électrique de commande est une impulsion électrique.

Le signal de commande traverse successivement la première électrode d'entrée 85, la première couche magnétique 95, la première couche non magnétique 100 la deuxième couche magnétique 102, et la première électrode de sortie 90.

Par effet de « transfert de spin », la deuxième direction variable d'aimantation V2 pivote de la première direction d'aimantation D1 à la troisième direction d'aimantation D3.

La troisième direction d'aimantation D3 étant parallèle à la deuxième direction d'aimantation D2, la deuxième direction variable d'aimantation V2 est parallèle à la deuxième direction d'aimantation D2.

En conséquence, la première direction variable d'aimantation V1 pivote par effet de couplage direct de la première direction d'aimantation D1 à la deuxième direction d'aimantation D2.

La première direction variable d'aimantation V1 est donc perpendiculaire à la première direction d'aimantation D1.

L'onde de spin SW ne se propage pas à travers la portion active 75.

Le premier rendement R1 est inférieur ou égal à 10⁻⁵. Le filtre 10 est dans l'état actif.

Le cas de figure décrit dans le premier exemple correspond à une configuration dans laquelle le filtre 10 présente un premier rendement R1 strictement supérieur à 10⁻⁵ (état dit « passant ») en l'absence de signal de commande.

On comprendra que si, en l'absence de signal de commande, la deuxième direction variable d'aimantation V1 est parallèle à la deuxième direction d'aimantation D2, le filtre 10 présente un premier rendement R1 inférieur ou égal à 10⁻⁵ (état dit « non passant). Le filtre 10 devient alors « passant » lors de l'application du signal de commande.

La figure 3 illustre un deuxième exemple d'organe de contrôle 35. Les éléments identiques au premier exemple des figures 1 et 2 ne sont pas représentés. Seules les différences sont mises en évidence.

Le deuxième empilement 80 comporte en outre une deuxième couche non magnétique 105.

La deuxième couche non magnétique 105 est sensiblement planaire. La deuxième couche non magnétique 105 est, de préférence, perpendiculaire à la direction d'empilement Z.

La deuxième couche non magnétique 105 est délimitée, selon la direction d'empilement Z, par la deuxième couche magnétique 102 et la portion active 75.

La deuxième couche non magnétique 105 est, par exemple, réalisée en cuivre.

La deuxième couche non magnétique 105 présente une septième épaisseur e7. La septième épaisseur e7 est, par exemple, comprise entre 1 nm et 30 nm.

La première électrode de sortie 90 est délimitée partiellement, selon la direction d'empilement Z, par la deuxième couche non magnétique 105.

Le fonctionnement du deuxième exemple de réalisation va maintenant être décrit. La première direction variable d'aimantation V1 est parallèle à la deuxième direction variable d'aimantation V2 par effet de « couplage dipolaire ». Cela signifie que la deuxième couche magnétique 102 génère un premier champ magnétique interne b1, et que le premier champ magnétique interne b1 exerce sur la portion active 75 un deuxième couple magnétique F2.

Le deuxième couple magnétique F2 force les moments magnétiques présents dans la portion active 75 à s'orienter préférentiellement dans la deuxième direction variable d'aimantation V2. Lorsque la deuxième direction variable d'aimantation V2 est modifiée, la première direction variable d'aimantation V1 est également modifiée.

La figure 4 illustre un troisième exemple d'organe de contrôle 35. Les éléments identiques au premier exemple des figures 1 et 2 ne sont pas représentés. Seules les différences sont mises en évidence.

L'organe de contrôle 35 comporte une couche de modulation 110.

L'organe de contrôle 35 est apte à générer une accumulation de spin dans la couche de modulation 110.

Cela signifie que l'organe de contrôle 35 est apte à générer un déplacement de particules présentant un moment magnétique dans la couche de modulation 110, de manière à accumuler préférentiellement dans une première zone les particules présentant un premier moment magnétique prédéfini, et dans une deuxième zone, les particules présentant un deuxième moment magnétique prédéfini.

Par exemple, les particules sont des électrons ayant un moment magnétique de spin égal à +1/2 ou un moment magnétique de spin égal à -1/2.

L'organe de contrôle 35 est apte à recevoir le signal de commande sur la première électrode d'entrée 85, et à le délivrer à travers la couche de modulation 110 à la première électrode de sortie 90.

Le signal de commande est un courant électrique, par exemple un courant continu. L'unité de génération 30 est apte à faire varier le sens du signal de commande entre un premier sens et un deuxième sens opposé au premier sens.

La couche de modulation 110 est sensiblement planaire. La couche de modulation 110 est perpendiculaire à la direction d'empilement Z.

La couche de modulation 110 présente une troisième face 115 en contact avec la deuxième face 65 et, une quatrième face 120 en regard de la troisième face 115.

La couche de modulation 110 présente une huitième épaisseur e8. La huitième épaisseur e8 est, par exemple, comprise entre 1 nm et 10 nm.

La couche de modulation 110 est en contact avec l'unité de guidage 15. Par exemple, la couche de modulation 110 est délimitée d'un côté, selon la direction d'empilement Z, par la première face 65 de la portion de guidage 15.

La couche de modulation 110 est, par exemple, réalisée en platine. En variante, la couche de modulation 110 est réalisée en un matériau isolant topologique tel que l'antimoniure de bismuth ou tout outre matériau présentant un fort couplage spin-orbite.

Un fort couplage spin-orbite est, en particulier, conventionnellement attribué aux éléments lourds du tableau périodique, par exemple les éléments qui présentent des couches 4d et 5d incomplètes tels que le platine, le tantale ou le tungstène.

Le fonctionnement du troisième exemple de réalisation va maintenant être décrit.

Lorsque le signal de commande traverse la couche de modulation 110, les électrons présentant un spin +1/2 sont préférentiellement déportés vers l'une de la troisième face 115 et la quatrième face 120. De manière similaire, les électrons présentant un spin -1/2 sont déportés préférentiellement vers l'autre de la troisième face 115 et de la quatrième face 120.

Pour une polarité donnée du signal de commande, par exemple positive, le signe du spin des électrons déportés vers la troisième face 115 dépend de la nature du matériau utilisé. Par exemple, lorsque la couche de modulation 110 est réalisée en platine, les électrons présentant un spin +1/2 sont déportés préférentiellement vers la troisième face 115, alors que, lorsque la couche de modulation 110 est réalisée en tantale ou en tungstène ce sont les électrons présentant un spin -1/2 qui sont déportés vers la troisième face.

Le spin des électrons accumulés à la troisième face 115 et à la quatrième face 120 dépend du sens du signal de commande traversant la couche de modulation 110.

Le premier sens du signal de commande provoque l'accumulation à la troisième face 115 d'électrons ayant un spin égal à +1/2, et à la quatrième face 120 d'électrons ayant un spin égal à -1/2. Le deuxième sens du signal de commande provoque l'accumulation à la troisième face 115 d'électrons ayant un spin égal à -1/2, et à la quatrième face 120 d'électrons ayant un spin égal à -1/2.

L'accumulation d'électrons présentant un spin commun à la troisième surface 115 modifie le coefficient d'atténuation α de l'onde de spin. Cet effet résulte du « transfert de spin ».

Lorsque le signal de commande circule dans le premier sens, le coefficient d'atténuation α de l'onde de spin est augmenté. La deuxième amplitude A2 est donc diminuée par rapport à sa valeur en l'absence de signal de commande

Plus l'intensité du signal de commande est importante, plus le coefficient d'atténuation α de l'onde de spin est augmenté. De préférence, la deuxième amplitude A2 en sortie de l'unité de guidage 47 est inférieure ou égale à 10⁻². Le filtre 10 est alors dans l'état « actif ».

Lorsque le signal de commande circule dans le deuxième sens, le coefficient d'atténuation α de l'onde de spin est diminué. Lorsque le signal de commande circule dans le deuxième sens, la deuxième amplitude A2 est donc augmentée par rapport à sa valeur en l'absence de signal de commande.

Plus l'intensité du signal de commande est importante, plus le coefficient d'atténuation α de l'onde de spin est diminué. Lorsque la densité de courant du signal de commande est supérieure à une valeur seuil VS, la deuxième amplitude A2 est supérieure à la première amplitude A1.

La valeur seuil VS dépend du matériau composant la couche de modulation 110 et de la huitième épaisseur e8. La valeur seuil VS est, par exemple, comprise strictement entre 10⁹ ampères par centimètre carré (A/cm²) et 10¹³ A/cm².

Le filtre 10 permet alors d'amplifier ou d'atténuer le signal de sortie OS par la modification de l'intensité et du sens du signal de commande.

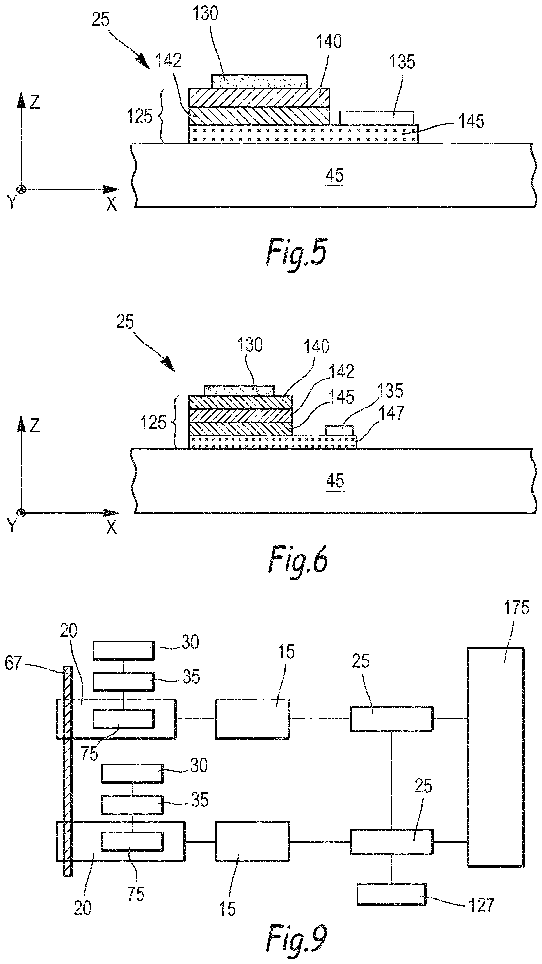

La figure 5 illustre un élément de sortie 25 d'un quatrième exemple de réalisation. Les éléments identiques au premier exemple des figures 1 et 2 ne sont pas représentés. Seules les différences sont mises en évidence.

L'élément de sortie 25 comprend un deuxième empilement 125 de couches magnétiques et non magnétiques, une alimentation électrique de sortie 127, une deuxième électrode d'entrée 130 et une deuxième électrode de sortie 135.

L'alimentation électrique de sortie 127 est apte à générer un courant électrique de sortie IS et à délivrer le courant électrique de sortie IS à la deuxième électrode d'entrée 130. L'alimentation électrique de sortie 127 est, par exemple, propre à imposer une tension électrique de sortie US continue entre la deuxième électrode d'entrée 130 et la deuxième électrode de sortie 135.

L'élément de sortie 25 est configuré pour que le courant électrique de sortie IS traverse le deuxième empilement 125. De préférence, l'élément de sortie 25 est configuré pour que le courant électrique de sortie IS traverse successivement chacune des couches du deuxième empilement 125.

Le deuxième empilement 125 présente une première résistance électrique R1 au passage du courant électrique de sortie IS.

Le deuxième empilement 125 comporte une couche de référence 140, une couche libre 145, et une couche barrière 142 réalisée en un matériau non magnétique.

De préférence, selon la direction d'empilement Z, la couche libre 145 est délimitée par la portion de sortie 45 et la couche barrière 142.

De préférence, la couche de référence 140 et la couche barrière 142 sont superposées.

La deuxième électrode d'entrée 130 est par exemple, réalisée sous la forme d'une couche de métal. La deuxième électrode d'entrée 130 est, par exemple, réalisée en or.

Sur la figure 5, la deuxième électrode d'entrée 130 est en contact avec la couche de référence 140.

La deuxième électrode de sortie 135 est, par exemple, réalisée sous la forme d'une couche de métal. La deuxième électrode de sortie 135 est, par exemple, réalisée en or.

Sur la figure 5, la deuxième électrode de sortie 135 est en contact avec la couche libre 145.

La couche de référence 140 est sensiblement planaire. La couche de référence 140 est, de préférence, perpendiculaire à la direction d'empilement Z.

La couche de référence 140 est réalisée en un quatrième matériau magnétique M4. Le quatrième matériau magnétique M4 est, par exemple, un matériau ferromagnétique. La couche de référence 140 est, par exemple, réalisée en un alliage de cobalt, de fer et de bore.

La couche de référence 140 présente une quatrième direction d'aimantation D4. La quatrième direction d'aimantation D4 est fixe.

La quatrième direction d'aimantation D4 est différente de la première direction d'aimantation D1. Par exemple, la quatrième direction d'aimantation D4 est perpendiculaire à la première direction d'aimantation D1 selon l'axe Y.

La couche de référence 140 présente une neuvième épaisseur e9. La neuvième épaisseur e9 est, par exemple, comprise entre 1 et 30 nanomètres.

La couche barrière 142 est sensiblement planaire. La couche barrière 142 est, de préférence, perpendiculaire à la direction d'empilement Z.

La couche barrière 142 est réalisée en un matériau non magnétique. La couche barrière 142 est, par exemple, réalisée en oxyde de magnésium.

La couche barrière 142 présente une épaisseur comprise, par exemple, entre 1 et 5 nanomètres.

La couche libre 145 est sensiblement planaire. La couche libre 145 est, de préférence, perpendiculaire à la direction d'empilement Z.

La couche libre 145 est réalisée en un cinquième matériau magnétique M5. Le cinquième matériau magnétique M5 est, par exemple, un matériau ferromagnétique. La couche libre 145 est, par exemple, réalisée en un alliage de cobalt, de fer et de bore.

La couche libre 145 présente une troisième direction variable d'aimantation V3. La troisième direction variable d'aimantation V3 est, de préférence, variable entre la première direction d'aimantation D1 et la deuxième direction d'aimantation D2.

La couche libre 145 présente une dixième épaisseur e10. La dixième épaisseur e10 est, par exemple, comprise entre 1 et 30 nanomètres.

Le fonctionnement du quatrième exemple de réalisation va maintenant être décrit.

Selon l'effet de « magnétorésistance tunnel », la première résistance électrique R1 dépend de l'angle formé entre la troisième direction variable d'aimantation V3 et la quatrième direction d'aimantation D4.

La troisième direction variable d'aimantation V3 est parallèle à la première direction d'aimantation D1 par effet de « couplage direct ».

Lorsque la première direction d'aimantation D1 est modifiée, la troisième direction variable d'aimantation V3 est également modifiée.

L'alimentation électrique de sortie 127 impose la tension électrique de sortie US entre la deuxième électrode d'entrée 130 et la deuxième électrode de sortie 135.

Le courant électrique de sortie IS traverse donc successivement la deuxième électrode d'entrée 130, la couche de référence 140, la couche barrière 142, la couche libre 145, et la deuxième électrode de sortie 135.

Lors du passage de l'onde de spin SW à travers la portion de sortie 45, les moments magnétiques présents dans la portion de sortie 45 sont animés d'un mouvement de précession autour de la direction D1. Les moments magnétiques sont donc déviés par rapport à la première direction d'aimantation D1.

Lors du passage de l'onde de spin SW à travers la portion de sortie 45, la troisième direction variable d'aimantation V3 est également déviée.

La première résistance électrique R1 est modifiée par le passage de l'onde de spin SW dans la portion de sortie 45. Le courant électrique de sortie IS est donc modifié par la propagation de l'onde de spin SW dans la portion de sortie 45.

En particulier, l'onde de spin SW génère, dans le courant électrique de sortie IS, des composantes radiofréquences de sortie.

La figure 6 illustre un élément de sortie 25 d'un cinquième exemple de réalisation. Les éléments identiques au quatrième exemple de la figure 5 ne sont pas représentés. Seules les différences sont mises en évidence.

Le premier empilement 125 comporte, en outre, une couche conductrice 147.

La couche conductrice 147 est réalisée en un cinquième matériau M5 électriquement conducteur. Le cinquième matériau M5 est un matériau non magnétique.

Par exemple, la couche conductrice 147 est réalisée en cuivre. La couche conductrice 147 est sensiblement planaire.

Selon la direction d'empilement Z, la couche conductrice 147 est délimitée par la couche libre 145 et la portion de sortie 45.

La couche conductrice 147 présente une onzième épaisseur e11. La onzième épaisseur e11 est, par exemple, comprise entre 1 et 30 nanomètres.

La deuxième électrode de sortie 135 est en contact avec la couche conductrice 147.

Le fonctionnement du cinquième exemple de réalisation va maintenant être décrit.

Par effet de couplage dipolaire, la troisième direction variable d'aimantation V3 est parallèle à la première direction d'aimantation D1.

Lorsque la première direction d'aimantation D1 est modifiée, la troisième direction variable d'aimantation V3 est également modifiée.

L'alimentation électrique de sortie 127 impose la tension électrique de sortie US entre la deuxième électrode d'entrée 130 et la deuxième électrode de sortie 135. Le courant électrique de sortie IS traverse successivement la deuxième électrode d'entrée 130, la couche de référence 140, la couche barrière 142, la couche libre 145, la couche conductrice 147 et la deuxième électrode de sortie 135.

La figure 7 illustre une portion structurée 47 d'un sixième exemple de réalisation. Les éléments identiques au premier exemple de la figure 1 ne sont pas représentés. Seules les différences sont mises en évidence.

Sur la figure 7, la portion structurée 47 est de forme parallélépipédique. La portion structurée 47 présente une longueur L selon la direction de propagation X, et une largeur I suivant la direction Y.

La longueur L est, par exemple, comprise entre 100 nm et 10 µm.

La largeur I est, par exemple, comprise entre 10 nm et 1 µm.

La portion structurée 47 comporte des premières portions 55 réalisées en premier matériau magnétique M1 et des deuxièmes portions 50 réalisées en un sixième matériau magnétique M6.

Les deuxièmes portions 50 sont, par exemple, réalisées par un bombardement ionique, destiné à modifier localement leur propriétés magnétiques.

Par exemple, le sixième matériau magnétique M6 est le premier matériau magnétique M1, dans lequel ont été implantés des ions manganèse.

Les premières portions 50 sont, par exemple, cylindriques à base circulaire. Les premières portions 50 présentent, par exemple, un premier diamètre d1 compris entre 5 nanomètres et 500 nanomètres.

En variante, les premières portions 50 sont carrées, et présentent un côté compris entre 5 nanomètres et 500 nanomètres.

Sur la figure 7, les premières portions 50 sont répétées selon un motif triangulaire. En variante, les premières portions 50 sont répétées selon un motif rectangulaire.

La période P est, par exemple, comprise entre 20 nanomètres et 1 µm.

Le fonctionnement de ce sixième exemple de réalisation est identique au fonctionnement du premier exemple de réalisation.

La figure 8 illustre une portion structurée 47 d'un septième exemple de réalisation. Les éléments identiques au sixième exemple de la figure 7 ne sont pas représentés. Seules les différences sont mises en évidence.

La portion structurée 47 comprend une couche de propagation 155 réalisée en le premier matériau magnétique M1. La couche de propagation 155 comporte une pluralité de trous borgnes 160. L'expression « trou borgne » désigne ici un trou ne traversant pas la totalité de la couche de propagation 155.

Sur la figure 8, les trous borgnes 160 sont arrangés selon un motif rectangulaire.

Sur la figure 8, les trous 160 sont cylindriques à base circulaire. Les trous 160 présentent un premier diamètre d1. Le premier diamètre d1 est, par exemple, compris entre 5 nm et 500 nm.

En variante, les trous 160 sont à base rectangulaire.

Le fonctionnement du septième exemple de réalisation est identique au fonctionnement du premier exemple de réalisation.

Un dispositif de filtrage 170 comprenant une pluralité de filtres 10 et un additionneur 175 est représenté sur la figure 9. Chacun des filtres 10 comporte un organe de commande 35 selon l'exemple de la figure 3. Chacun des filtres 10 comporte un organe de sortie 25 selon l'exemple de la figure 5.

De préférence, au moins un filtre 10 est différent de chacun des autres filtres 10.

Par exemple, l'unité de guidage 15 d'au moins un des filtres 10 présente un premier ensemble de fréquences E1 différent du premier ensemble de fréquences E1 de chacun des autres filtres 10, et un deuxième ensemble de fréquence E2 différent du deuxième ensemble de fréquences E2 de chacun des autres filtres 10.

Sur la figure 9, les éléments d'entrée 20 de chacun des filtres partagent une seule antenne 67. L'antenne 67 apte à générer simultanément une onde de spin SW dans la portion de génération 70 de chacun des éléments d'entrée 20.

Les éléments de sortie 25 de chacun des filtres 10 partagent une même alimentation électrique de sortie 127. L'alimentation électrique de sortie 127 impose la tension électrique de sortie US entre la deuxième électrode d'entrée 130 et la deuxième électrode de sortie 135 de chacun des filtres 10.

L'unité de génération 30 de chacun des filtres 10 est indépendante. C'est-à-dire que l'unité de génération 30 de chacun des filtres 10 peut être activée indépendamment de chacune des autres unités de génération 30.

L'additionneur 175 est connecté à l'élément de sortie 25 de chacun des filtres 10. L'additionneur 175 est configuré pour recevoir de chaque élément de sortie 25 un signal de sortie OS respectif.

L'additionneur 175 est configuré pour générer un signal composé à partir d'au moins un des signaux de sortie OS reçu des différents filtres 10.

Le fonctionnement du dispositif de filtrage 170 va maintenant être décrit. Dans un état initial, tous les filtres 10 du dispositif de filtrage 170 sont dans l'état passif.

Dans une première étape, un premier groupe G1 de filtres 10 est sélectionné pour basculer dans l'état actif. L'unité de génération 30 de chacun des filtres 10 du premier groupe G1 génère une impulsion électrique qu'elle délivre à l'organe de commande 35 correspondant. Chacun des filtres 10 du premier groupe passe alors dans l'état actif.

Dans une deuxième étape, l'antenne 67 génère une onde de spin SW dans la portion de génération de chacun des filtres 10.

Chacun des filtres 10 en mode passif génère un signal de sortie OS radiofréquence. Chacun des filtres 10 en mode non actif ne génère pas de signal de sortie OS radiofréquence.

L'additionneur 175 reçoit ensuite l'ensemble des signaux de sortie OS de chacun des filtres 10 dans l'état passif, et génère un signal composé à partir de l'ensemble des signaux de sortie.

Dans une dernière étape, un nouveau groupe G2 de filtres 10 est sélectionné pour être actif. L'unité de génération 30 de chacun des filtres 10 devant passer de l'état passif à l'état actif est alors activée.

Le dispositif de filtrage 170 permet alors de sélectionner un ou plusieurs des filtres 10. Les filtres 10 étant différents les uns des autres, le dispositif de filtrage 170 présente une fonction de transfert modifiable par l'utilisateur.

De plus, le dispositif de filtrage 170 présente une surface de l'ordre de 1 mm². Le dispositif de filtrage 170 est donc de petite taille.

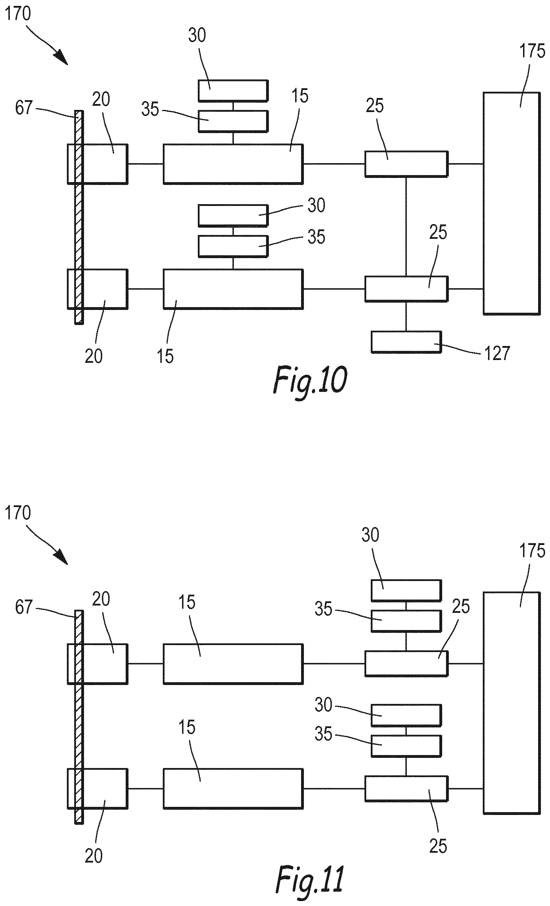

La figure 10 illustre un deuxième exemple de réalisation du dispositif de filtrage 170 selon l'invention. Les éléments identiques au premier exemple de la figure 9 ne sont pas décrits à nouveau. Seules les différences sont mises en évidence.

Dans cet exemple, chacun des organes de contrôle 35 est conforme à l'exemple de la figure 4.

Le dispositif de filtrage 170 permet alors d'amplifier sélectivement certaines composantes de sortie du signal de sortie OS par action sur le signal de commande d'un ou plusieurs filtres correspondants.

La figure 11 illustre un troisième exemple de réalisation du dispositif de filtrage 170 selon l'invention. Les éléments identiques au premier exemple de la figure 9 ne sont pas décrits à nouveau. Seules les différences sont mises en évidence.

Dans ce mode de réalisation, l'unité de génération 30 d'un signal de commande est connectée à l'élément de sortie 25. Chacun des éléments de sortie 25 est conforme à l'exemple de la figure 5 ou à l'exemple de la figure 6.

L'unité de génération 30 est apte à délivrer le signal de commande la deuxième électrode d'entrée 130. Le signal de commande est un courant électrique continu. Chaque unité de génération 30 est indépendante.

L'organe de sortie 25 joue ici également le rôle d'organe de contrôle 35.

Lorsque l'unité de génération 30 délivre un courant continu à l'élément de sortie 25, le signal de commande est modulé par le passage d'une onde de spin dans la portion de sortie 45. Seuls les filtres 10 dont l'unité de génération 30 est activée, génèrent donc un signal de sortie OS.

Les signaux de commande sont ensuite délivrés à l'additionneur 175.

La fabrication du dispositif de filtrage 170 est alors simplifiée.

Dans un dernier exemple de réalisation non représenté, plusieurs filtres 10 partagent la même unité de génération 30. L'unité de génération 30 est apte à délivrer le signal de commande simultanément à chacun des organes de commande 35 de chacun des filtres 10 correspondants.

Le fonctionnement du dispositif de filtrage 170 dans le dernier exemple de réalisation est similaire au fonctionnement du dispositif de filtrage 170 dans l'exemple de la figure 9.

Le dispositif de filtrage 170 permet d'augmenter, par construction, l'amplitude de sortie AS de certaines des composantes de sortie.

Il est à noter que, dans chacun des exemples précédents, l'organe de contrôle 35 comporte deux électrodes 85, 90 permettant la transmission d'un signal électrique de commande à travers une couche 102, 105 ou 110. La couche 102, 105 ou 110 est en contact avec l'unité de guidage 15 et appartient à l'organe de contrôle 35.

## Revendications

1. Filtre (10) pour ondes radiofréquences comprenant :
- une unité de guidage (15) d'ondes de spin comprenant un matériau magnétique, l'unité de guidage (15) étant agencée spatialement pour générer un potentiel magnétostatique modulé spatialement, le potentiel magnétostatique permettant la propagation d'ondes de spin présentant une fréquence appartenant à un premier ensemble de fréquences et empêchant la propagation d'ondes de spin présentant une fréquence appartenant à un deuxième ensemble de fréquences, le deuxième ensemble de fréquences étant distinct du premier ensemble de fréquences, un taux de transmission étant défini pour l'unité de guidage (15), le taux de transmission étant égal au rapport de la deuxième amplitude (A2) de l'onde en sortie de l'unité de guidage (15) et de la première amplitude (A1) de l'onde en entrée de l'unité de guidage (15),
- un élément d'entrée (20) de l'unité de guidage (15), l'élément d'entrée (20) étant apte à convertir avec un premier rendement, une onde électromagnétique radiofréquence en une onde de spin,
- un élément de sortie (25) de l'unité de guidage (15), l'élément de sortie (25) étant apte à convertir avec un deuxième rendement, une onde de spin en un signal de sortie (OS) radiofréquence,
- une unité de génération (30) d'au moins un signal électrique de commande, et
- un organe de contrôle (35),
**caractérisé en ce que** l'organe de control est propre à modifier l'un au moins parmi le premier rendement, le deuxième rendement et le taux de transmission en réponse au signal électrique de commande que l'unité de génération (30) est propre à générer, l'organe de contrôle (35) comportant une couche (102, 105, 110) en contact avec l'unité de guidage (15) et deux électrodes (85, 90) configurées pour permettre la transmission du signal électrique de commande à travers ladite couche (102, 105, 110) en contact avec l'unité de guidage (15).

2. Filtre selon la revendication 1, dans lequel l'élément d'entrée (20) comprend une portion active (75), la portion active (75) étant réalisée en un matériau magnétique, l'organe de contrôle (35) comportant un premier empilement (80) d'au moins une première couche magnétique (95), et d'une couche non magnétique (100), la direction d'aimantation de la première couche magnétique (95) étant fixe, et l'organe de contrôle (35) étant propre à modifier la direction de l'aimantation de la portion active (75).

3. Filtre (10) selon la revendication 1, dans lequel l'organe de contrôle (35) comprend une couche de modulation (110) ayant une première face (115) en contact avec l'unité de guidage (15), l'organe de contrôle (35) étant apte à provoquer l'accumulation à la première face (115) d'électrons présentant une même valeur de spin.

4. Filtre (10) selon la revendication 3, dans lequel l'organe de contrôle (35) est propre à modifier la deuxième amplitude (A2) entre une première valeur et une deuxième valeur, la deuxième valeur étant supérieure à la première amplitude (A1).

5. Filtre (10) selon l'une quelconque des revendications 1 à 4, dans lequel l'élément de sortie (25) comporte un deuxième empilement (125) de couches magnétiques et non magnétiques comprenant au moins une couche réalisée en un matériau magnétique, dite couche de référence (140), dont la direction de l'aimantation est fixée, et au moins une couche réalisée en un matériau non magnétique, dite couche barrière (145), l'élément de sortie (25) étant propre à générer un courant électrique traversant successivement au moins la couche de référence (140) et la couche barrière (142).

6. Filtre (10) selon l'une quelconque des revendications 1 à 5, dans lequel l'unité de guidage (15) est propre à permettre la propagation d'une onde de spin dans une direction de propagation, l'unité de guidage (15) comportant des premières portions (50) réalisées en matériau dopé et des deuxièmes portions (55) réalisées en matériau non dopé, les premières portions (50) étant arrangées sous forme d'un motif répété périodiquement dans la direction de propagation de l'onde de spin.

7. Filtre (10) selon l'une quelconque des revendications 1 à 6, dans lequel l'unité de guidage (15) est propre à permettre la propagation d'une onde de spin dans une direction de propagation, l'unité de guidage (15) comportant une couche de propagation (155) réalisée en un matériau magnétique, la couche de propagation (155) présentant une pluralité de trous (160) borgnes, les trous (160) étant arrangés sous forme d'un motif répété périodiquement dans la direction de propagation de l'onde de spin.

8. Dispositif de filtrage comprenant une pluralité de filtres (10) selon l'une quelconque des revendications 1 à 7, générant une pluralité de signaux de sortie (OS), la pluralité de filtres (10) comprenant un premier filtre (10) comportant une première unité de génération (30) de signal de commande et au moins un deuxième filtre (10) comportant une deuxième unité de génération (30) de signal de commande, le deuxième filtre (10) étant différent du premier filtre (10), dans lequel la première unité de génération (30) de signal de commande est indépendante de la deuxième unité de génération (30) de signal de commande.

9. Dispositif de filtrage comprenant une pluralité de filtres (10) selon l'une quelconque des revendications 1 à 7 générant une pluralité de signaux de sortie (OS), la pluralité de filtres (10) comprenant un premier filtre (10) et au moins un deuxième filtre (10) différent du premier filtre (10), le premier filtre (10) comprenant un premier organe de contrôle (35) commandé par un signal de commande et le deuxième filtre (10) comprenant un deuxième organe de contrôle (35) commandé par le même signal de commande.

## Patentansprüche

1. Filter (10) für Hochfrequenzwellen, aufweisend:
- eine Spinwellen-Leiteinheit (15), die ein magnetisches Material aufweist, wobei die Leiteinheit (15) räumlich angeordnet ist, um ein räumlich moduliertes magnetostatisches Potential zu erzeugen, wobei das magnetostatische Potential die Ausbreitung von Spinwellen mit einer Frequenz erlaubt, die zu einem ersten Satz von Frequenzen gehört, und die Ausbreitung von Spinwellen mit einer Frequenz, die zu einem zweiten Satz von Frequenzen gehört, verhindert, wobei der zweite Satz von Frequenzen von dem ersten Satz von Frequenzen unterschiedlich ist; wobei für die Führungseinheit (15) eine Übertragungsrate eingestellt ist, wobei die Übertragungsrate gleich dem Verhältnis der zweiten Amplitude (A2) der Ausgangswelle der Führungseinheit (15) und der ersten Amplitude (A1) der Eingangswelle der Führungseinheit (15) ist,
- ein Eingangselement (20) der Führungseinheit (15), wobei das Eingangselement (20) geeignet ist, eine hochfrequente elektromagnetische Welle mit einem ersten Wirkungsgrad in eine Spinwelle umzuwandeln,
- ein Ausgangselement (25) der Führungseinheit (15), wobei das Ausgangselement (25) geeignet ist, mit einem zweiten Wirkungsgrad eine Spinwelle in ein hochfrequentes Ausgangssignal (OS) umzuwandeln,
- eine Einheit zum Erzeugen (30) mindestens eines elektrischen Steuersignals und
- ein Steuerelement (35),
dadurch charakterisiert, dass das Steuerelement geeignet ist, wenigstens eines zu modifizieren von dem ersten Wirkungsgrad, dem zweiten Wirkungsgrad und der Übertragungsrate in Reaktion auf das elektrische Steuersignal, das die Erzeugungseinheit (30) erzeugen kann, wobei das Steuerelement (35) eine Schicht (102, 105, 110) in Kontakt mit der Führungseinheit (15) und zwei Elektroden (85, 90) aufweist, die dazu eingerichtet sind, die Übertragung des elektrischen Steuersignals zu der Schicht (102, 105, 110) in Kontakt mit der der Führungseinheit (15) zu ermöglichen.

2. Filter nach Anspruch 1, wobei das Eingangselement (20) einen aktiven Abschnitt (75) aufweist, wobei der aktive Abschnitt (75) aus einem magnetischen Material besteht, wobei das Steuerelement (35) einen ersten Stapel (80) von mindestens einer ersten magnetischen Schicht (95) und einer nichtmagnetischen Schicht (100) aufweist, wobei die Magnetisierungsrichtung der ersten magnetischen Schicht (95) fest ist, und das Steuerelement (35) geeignet ist, die Richtung der Magnetisierung des aktiven Abschnitts (75) zu modifizieren.

3. Filter (10) nach Anspruch 1, wobei das Steuerelement (35) eine Modulationsschicht (110) mit einer ersten Fläche (115) in Kontakt mit der Führungseinheit (15) aufweist, wobei das Steuerelement (35) geeignet ist, die Ansammlung von Elektronen mit dem gleichen Spinwert an der ersten Fläche (115) zu bewirken.

4. Filter (10) nach Anspruch 3, wobei das Steuerelement (35) geeignet ist, die zweite Amplitude (A2) zwischen einem ersten Wert und einem zweiten Wert zu ändern, wobei der zweite Wert größer als die erste Amplitude (A1) ist.

5. Filter (10) nach einem der Ansprüche 1 bis 4, wobei das Ausgangselement (25) einen zweiten Stapel (125) magnetischer und nichtmagnetischer Schichten aufweist, der mindestens eine Schicht aus einem magnetischen Material, Referenzschicht (140) genannt, deren Magnetisierungsrichtung festgelegt ist, und mindestens eine Schicht aus einem nichtmagnetischen Material, Barriereschicht (145) genannt, aufweist, wobei das Ausgangselement (25) geeignet ist, einen elektrischen Strom zu erzeugen, der nacheinander mindestens durch die Referenzschicht (140) und die Barriereschicht (142) fließt.

6. Filter (10) nach einem der Ansprüche 1 bis 5, wobei die Führungseinheit (15) dazu geeignet ist, die Ausbreitung einer Spinwelle in einer Ausbreitungsrichtung zu ermöglichen, wobei die Führungseinheit (15) erste Abschnitte (50) aus dotiertem Material und zweite Abschnitte (55) aus undotiertem Material aufweist, wobei die ersten Abschnitte (50) periodisch in Form eines periodisch wiederholten Musters in der Ausbreitungsrichtung der Spin-Welle angeordnet sind.

7. Filter (10) nach einem der Ansprüche 1 bis 6, wobei die Leiteinheit (15) dazu geeignet ist, die Ausbreitung einer Spinwelle in der Ausbreitungsrichtung zu ermöglichen, wobei die Leiteinheit (15) eine Ausbreitungsschicht (155) aus einem magnetischen Material aufweist, wobei die Ausbreitungsschicht (155) mehrere Sacklöcher (160) aufweist, wobei die Löcher (160) als periodisch wiederholtes Muster in der Ausbreitungsrichtung der Spinwelle angeordnet sind.

8. Filtervorrichtung mit mehreren Filtern (10) nach einem der Ansprüche 1 bis 7, die mehrere Ausgangssignale (OS) erzeugen, wobei die mehreren Filter (10) ein erstes Filter (10) mit einer ersten Steuersignalerzeugungseinheit (30) und mindestens ein zweites Filter (10) mit einer zweiten Steuersignalerzeugungseinheit (30) aufweisen, wobei sich das zweite Filter (10) vom ersten Filter (10) unterscheidet, wobei die erste Steuersignalerzeugungseinheit (30) unabhängig von der zweiten Steuersignalerzeugungseinheit (30) ist.

9. Filtervorrichtung mit mehreren Filtern (10) nach einem der Ansprüche 1 bis 7, die mehrere Ausgangssignale (OS) erzeugen, wobei die mehreren Filter (10) ein erstes Filter (10) und mindestens ein zweites Filter (10), das sich von dem ersten Filter (10) unterscheidet, aufweisen, wobei das erste Filter (10) ein erstes Steuerelement (35) aufweist, das von einem Steuersignal gesteuert wird, und das zweite Filter (10) ein zweites Steuerelement (35) aufweist, das von dem gleichen Steuersignal gesteuert wird.

## Claims

1. Filter (10) for radiofrequency waves, comprising:
- a guide unit (15) for spin waves comprising a magnetic material, the guide unit (15) being spatially arranged to generate a spatially modulated magnetostatic potential, the magnetostatic potential allowing the propagation of spin waves having a frequency belonging to a first set of frequencies and preventing the propagation of spin waves having a frequency belonging to a second set of frequencies, the second set of frequencies being distinct from the first set of frequencies, a transmission rate being defined for the guide unit (15), the transmission rate being equal to the ratio of the second amplitude (A2) of the wave at the output of the guide unit (15) and the first amplitude (A1) of the wave at the input of the guide unit (15),
- an input element (20) of the guide unit (15), the input element (20) being capable of converting, with a first efficiency, a radiofrequency electromagnetic wave into a spin wave,
- an output element (25) of the guide unit (15), the output element (25) being capable of converting, with a second efficiency, a spin wave into a radiofrequency output signal (OS),
- a generating unit (30) for generating at least one electrical control signal, and
- a control member (35),
**characterised in that** the control member is capable of modifying at least one of the first efficiency, the second efficiency and the transmission rate in response to the electrical control signal that the generating unit (30) is capable of generating, the control member (35) comprising a layer (102, 105, 110) in contact with the guide unit (15) and two electrodes (85, 90) configured to allow the transmission of the electrical control signal through said layer (102, 105, 110) in contact with the guide unit (15).

2. Filter according to claim 1, wherein the input element (20) comprises an active portion (75), the active portion (75) being made of a magnetic material, the control member (35) comprising a first stack (80) of at least a first magnetic layer (95) and a non-magnetic layer (100), the magnetisation direction of the first magnetic layer (95) being fixed, and the control member (35) being capable of modifying the magnetisation direction of the active portion (75).

3. Filter (10) according to claim 1, wherein the control member (35) comprises a modulating layer (110) having a first face (115) in contact with the guide unit (15), the control member (35) being capable of causing the accumulation at the first face (115) of electrons having the same spin value.

4. Filter (10) according to claim 3, wherein the control member (35) is capable of modifying the second amplitude (A2) between a first value and a second value, the second value being greater than the first amplitude (A1).

5. Filter (10) according to any one of claims 1 to 4, wherein the output element (25) comprises a second stack (125) of magnetic and non-magnetic layers comprising at least one layer made of a magnetic material, called a reference layer (140), the magnetisation direction of which is fixed, and at least one layer made of a non-magnetic material, called a barrier layer (145), the output element (25) being capable of generating an electric current which passes in succession through at least the reference layer (140) and the barrier layer (142).

6. Filter (10) according to any one of claims 1 to 5, wherein the guide unit (15) is capable of allowing the propagation of a spin wave in a propagation direction, the guide unit (15) comprising first portions (50) made of doped material and second portions (55) made of non-doped material, the first portions (50) being arranged in the form of a pattern repeated periodically in the propagation direction of the spin wave.

7. Filter (10) according to any one of claims 1 to 6, wherein the guide unit (15) is capable of allowing the propagation of a spin wave in a propagation direction, the guide unit (15) comprising a propagation layer (155) made of a magnetic material, the propagation layer (155) having a plurality of blind holes (160), the holes (160) being arranged in the form of a pattern repeated periodically in the propagation direction of the spin wave.

8. Filtering device comprising a plurality of filters (10) according to any one of claims 1 to 7, generating a plurality of output signals (OS), the plurality of filters (10) comprising a first filter (10) comprising a first control signal generating unit (30) and at least a second filter (10) comprising a second control signal generating unit (30), the second filter (10) being different from the first filter (10), wherein the first control signal generating unit (30) is independent of the second control signal generating unit (30).

9. Filtering device comprising a plurality of filters (10) according to any one of claims 1 to 7, generating a plurality of output signals (OS), the plurality of filters (10) comprising a first filter (10) and at least a second filter (10) which is different from the first filter (10), the first filter (10) comprising a first control member (35) controlled by a control signal and the second filter (10) comprising a second control member (35) controlled by the same control signal.
